# FASCICULE DE BREVET EUROPEEN

(11) **EP 2 044 453 B1**
(45) Date de publication et mention de la délivrance du brevet: **01.09.2010**
(21) Numéro de dépôt: 07823541.3
(22) Date de dépôt: 03.07.2007
(51) Int. Cl.: G01R 31/36, G01R 19/165, G01R 19/10

(54) **DISPOSITIF DE MESURE DE PARAMETRES D'UNE SOURCE D'ALIMENTATION ELECTRIQUE**
VORRICHTUNG ZUR MESSUNG VON PARAMETERN EINES ELEKTRISCHEN NETZTEILS
DEVICE FOR MEASURING PARAMETERS OF AN ELECTRICAL POWER SUPPLY

(30) Priorité: 05.07.2006 FR 0652800
(43) Date de publication de la demande: 08.04.2009
(73) Titulaire: Valeo Electronique et Systèmes de Liaison, 78180 Montigny le Bretonneux (FR)
(72) Inventeur: BOSNJAK, Joseph, 78760 Jouars (FR); THIMON, Alain, 93230 Romainville (FR)
(74) Mandataire: de Lambilly Delorme, Marie Pierre
(86) Numéro de dépôt international: PCT/FR2007/051585
(87) Numéro de publication internationale: WO 2008/003898

(56) Documents cités:
- EP-A1- 0 913 698
- FR-A1- 2 874 702

## Description

La présente invention concerne un dispositif de mesure de paramètres d'une source d'alimentation électrique.

Elle s'applique plus particulièrement à la mesure de paramètres d'une batterie d'un véhicule automobile, par exemple une intensité, une tension ou encore une température.

Dans ce qui suit, on appellera acquisition d'un paramètre, l'acquisition d'une grandeur électrique destinée à définir ce paramètre.

On connaît déjà, dans l'état de la technique, par exemple par le document FR-2 874 702 A, un dispositif de mesure de paramètres, du type comprenant une chaîne d'acquisition et de traitement de données comportant :
- un premier élément d'acquisition d'un premier paramètre alimenté par une tension définie par la différence entre un potentiel de source d'alimentation électrique et un potentiel supérieur à ce potentiel de source et destiné à conditionner un signal de tension, dit signal à la source, correspondant aux données, ayant pour référence le potentiel de source, le premier paramètre étant une intensité d'un courant circulant dans un circuit raccordé au potentiel de source et étant fourni par un shunt relié à ce circuit,
- un second élément d'acquisition d'un second paramètre fourni par un pont diviseur de tension raccordé au potentiel de source.

Habituellement, le potentiel de source est la borne positive de la batterie et le potentiel supérieur au potentiel de source est fourni par un élément d'alimentation formant élévateur de tension.

Ainsi, le premier élément d'acquisition relève aux bornes du shunt une différence de potentiel liée à l'intensité à mesurer.

Comme le premier élément d'acquisition de l'intensité a pour référence le potentiel de source, il est sensible à de relativement faibles variations de potentiel autour de ce potentiel de source et fournit une mesure relativement précise de l'intensité.

Le second paramètre fourni par le pont diviseur est par exemple une tension définie par la différence entre le potentiel de source et un potentiel de masse.

Les éléments d'acquisition conditionnent des signaux de tension, correspondant aux données, et les transmettent par exemple à un élément de traitement des données des paramètres.

Dans l'état de la technique, les premier et deuxième éléments d'acquisition sont regroupés dans un premier composant raccordé au potentiel de source et l'élément de traitement ainsi que d'autres éléments de la chaîne, tels que notamment un élément de communication avec un organe électrique extérieur à la chaîne, sont regroupés dans un second composant raccordé au potentiel de masse.

Ainsi, le premier composant est alimenté par une tension définie par la différence entre le potentiel supérieur et le potentiel de source tandis que le second composant est alimenté, par exemple, par une tension définie par la différence entre un potentiel intermédiaire, compris entre le potentiel de source et le potentiel de masse, et le potentiel de masse.

De façon classique, les éléments du premier composant échangent des signaux de tension avec les éléments du second composant par l'intermédiaire d'un élément d'adaptation. L'élément d'adaptation est ainsi destiné à adapter le potentiel de référence du signal à la source au potentiel de référence du signal à la masse et réciproquement.

La mesure de courant doit être réalisable aussi bien lorsque le moteur du véhicule automobile tourne que lorsque le moteur est à l'arrêt.

En effet, lorsque le moteur est à l'arrêt, certains organes du véhicule automobile sont maintenus en état de veille afin de réaliser des fonctions, par exemple, de mémorisation, et de ce fait doivent être alimentés continûment en courant.

Ainsi, il est souhaitable de réaliser des mesures de courant même lorsque le moteur est à l'arrêt afin de détecter une consommation anormale du courant lié, par exemple, à un dysfonctionnement éventuel d'un de ces organes électriques en état de veille.

Par conséquent, l'élévateur de tension doit alimenter continûment le premier élément d'acquisition et donc les éléments du premier composant, ce qui risque de provoquer une décharge de la batterie, en particulier lorsque le moteur est à l'arrêt, due à une consommation de courant trop élevé.

L'invention a notamment pour but de proposer un dispositif de mesure ayant une consommation de courant limitée tout en permettant de réaliser des mesures précises de l'intensité du courant.

A cet effet, l'invention a pour objet un dispositif de mesure du type précité, **caractérisé en ce que** le second élément d'acquisition est alimenté par une tension définie par la différence entre un potentiel de masse, inférieur au potentiel de source, et un potentiel intermédiaire compris entre le potentiel de masse et le potentiel de source, et est destiné à conditionner un signal de tension, dit signal à la masse, correspondant aux données, ayant pour référence le potentiel de masse.

Comme le premier élément d'acquisition a pour référence le potentiel de source, l'acquisition de relativement faibles différences de potentiel autour de ce potentiel de source fournit une mesure relativement précise de l'intensité du courant.

Par ailleurs, le second élément d'acquisition, ne nécessitant pas d'avoir pour potentiel de référence le potentiel de source, est avantageusement alimenté par une tension définie par la différence entre le potentiel intermédiaire et le potentiel de masse et n'est donc plus alimenté par l'élévateur de tension.

Ainsi, la consommation de courant des éléments de la chaîne est limitée et ce sans nuire à la précision de la mesure des paramètres.

Un dispositif de mesure selon l'invention peut en outre comporter l'une ou les caractéristiques suivantes :
- le second paramètre est une tension définie par la différence entre le potentiel de source et le potentiel de masse fournie par le pont diviseur de tension au second élément d'acquisition ;
- le second paramètre est une température fournie par le pont diviseur de tension au second élément d'acquisition, ce pont diviseur de tension comprenant au moins une thermistance ;
- la chaîne comprend de plus un élément de traitement d'au moins le premier paramètre, alimenté par une tension définie par la différence entre le potentiel de masse et le potentiel intermédiaire ;
- la chaîne comprend un élément de communication avec un organe électrique extérieur à cette chaîne, cet élément de communication étant alimenté par une tension définie par la différence entre le potentiel de masse et le potentiel intermédiaire ;
- la chaîne comprend un élément comparateur de l'intensité acquise avec un seuil d'intensité prédéterminé, alimenté par une tension définie par la différence entre le potentiel de source et le potentiel supérieur à ce potentiel de source, cet élément comparateur étant destiné à conditionner un signal de tension d'activation/désactivation d'au moins un élément de la chaîne alimenté par une tension définie par la différence entre le potentiel de masse et le potentiel intermédiaire, en fonction du franchissement à la hausse/à la baisse du seuil par l'intensité acquise, le signal ayant pour référence le potentiel de source ;
- la chaîne comprend de plus un élément d'adaptation, reliant un premier ensemble d'éléments de la chaîne comprenant au moins le premier élément d'acquisition, chaque élément du premier ensemble étant alimenté par une tension définie par une différence entre le potentiel de source et le potentiel supérieur au potentiel de source avec un second ensemble d'éléments de la chaîne comprenant au moins le second élément d'acquisition, chaque élément du second ensemble étant alimenté par une tension définie par une différence entre le potentiel de masse et le potentiel intermédiaire, de façon à adapter le potentiel de référence du signal à la source au potentiel de référence du signal à la masse et réciproquement ;
- le dispositif comprend une pastille semi-conductrice dans laquelle sont regroupés les premier et second ensembles d'éléments de la chaîne ;
- le dispositif comprend des première et seconde pastilles semi-conductrices dans lesquelles sont répartis respectivement les premier et deuxième ensembles d'éléments de la chaîne ;
- le dispositif comprend des première et seconde pastilles semi-conductrices comportant chacune des pistes reliées à des éléments de la chaîne, les pistes de la deuxième pastille ont des dimensions plus faibles que les pistes de la première pastille ;
- le potentiel de source est une borne positive de batterie de véhicule automobile ;
- le potentiel intermédiaire est fourni par un élément d'alimentation formant régulateur de tension, alimenté par une tension définie par la différence entre le potentiel de source et le potentiel de masse ;
- le régulateur de tension est relié au potentiel de source par l'intermédiaire d'un élément de filtrage de tension ;
- le potentiel supérieur au potentiel de source est fourni par un élément d'alimentation formant élévateur de tension, alimenté par une tension définie par la différence entre le potentiel de source et le potentiel de masse ;
- l'élévateur de tension est relié au potentiel de source par l'intermédiaire d'un élément de filtrage de tension.

L'invention sera mieux comprise à la lecture de la description qui va suivre, donnée uniquement à titre d'exemple et faite en se référant aux dessins dans lesquels :
- la figure 1 est un schéma d'un dispositif de mesure selon l'invention ;
- la figure 2 est un schéma d'une variante du dispositif de la figure 1.

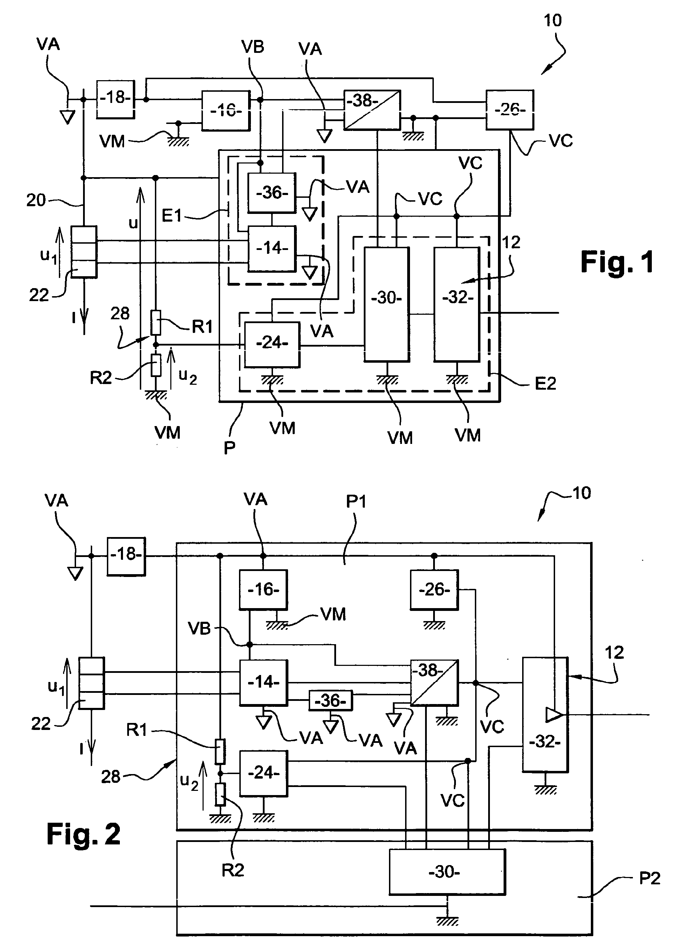

On a représenté sur la figure 1 un dispositif de mesure de paramètres selon l'invention désigné par la référence générale 10.

Plus particulièrement, ce dispositif 10 est destiné à mesurer des paramètres d'une batterie d'un véhicule automobile (non représentée).

Le dispositif 10 comprend une chaîne 12 d'acquisition et de traitement de données.

En particulier, la chaîne 12 comprend un premier élément 14 d'acquisition d'un premier paramètre.

Ce premier élément d'acquisition 14 est alimenté par une tension définie par la différence entre un potentiel VA de source d'alimentation électrique et un potentiel VB supérieur à ce potentiel de source VA.

Dans l'exemple décrit, le potentiel de source VA est une borne positive de la batterie du véhicule automobile et a une valeur d'environ 12 Volts.

Le potentiel VB supérieur à ce potentiel de source VA est fourni par un élément d'alimentation 16 formant élévateur de tension et a, par exemple, une valeur d'environ 18 Volts. L'élévateur de tension 16 est par exemple du type à pompe de charge.

L'élévateur de tension 16 est alimenté par une tension définie par la différence entre le potentiel de source VA et un potentiel de masse VM. Dans l'exemple décrit, le potentiel de masse VM est une borne négative de la batterie.

De préférence, l'élévateur de tension 16 et l'élément d'acquisition 14 sont reliés au potentiel de source VA par l'intermédiaire d'un élément 18 de filtrage de tension.

Cet élément de filtrage 18 fournit en sortie un potentiel de source d'alimentation électrique filtrée afin de protéger l'élévateur de tension 16 ainsi que les éléments de la chaîne 12 alimentés par l'élévateur 16 ou reliés au potentiel de source VA de variations intempestives du potentiel VA, telles que des surtensions, des coupures brutales, etc..

Le premier paramètre est une intensité I d'un courant circulant dans un circuit 20 relié à la borne positive de la batterie.

A cet effet, la chaîne 12 comprend un shunt 22 relié au circuit 20 et au premier élément d'acquisition 14. Le shunt 22 a par exemple une résistance de valeur 100 µΩ.

Ainsi, le premier élément d'acquisition 14 relève une tension U1 définie par la différence de potentiel aux bornes du shunt 22, cette tension U1 étant, de façon connue en soi, proportionnelle à l'intensité I à mesurer.

La chaîne 12 comprend encore un second élément 24 d'acquisition d'un second paramètre.

Conformément à l'invention, le second élément d'acquisition 24 est alimenté par une tension définie entre d'une part, un potentiel intermédiaire VC compris entre le potentiel de source filtré VA et le potentiel de masse VM, et d'autre part, le potentiel de masse VM.

De préférence, le potentiel intermédiaire VC est fourni par un élément d'alimentation 26 formant régulateur de tension. Ce régulateur de tension 26 est alimenté par une tension définie par la différence entre le potentiel de source VA et le potentiel de masse VM.

De façon analogue à l'élévateur 16, le régulateur 26 est relié au potentiel de source VA, par l'intermédiaire de l'élément de filtrage 18 afin de protéger d'une part le régulateur 26 mais également les éléments de la chaîne 12 alimentés par ce régulateur 26.

Plus particulièrement, le second paramètre est une tension U définie par la différence entre le potentiel de source VA et le potentiel de masse VM et est fournie par un pont 28 diviseur de tension raccordé au potentiel de source VA au second élément d'acquisition 24.

Ainsi, de façon classique et comme illustré sur la figure, le pont diviseur de tension 28 comprend deux résistances R1 et R2. Le deuxième élément d'acquisition 24 est destiné à relever la tension U2 définie par la différence de potentiel aux bornes de la résistance R2. Cette tension U2 est proportionnelle à la tension U à mesurer.

Le second paramètre peut être une température. Dans ce cas, le dispositif 10 peut éventuellement comporter un autre pont diviseur de tension (non représenté). Cet autre pont diviseur comprend, par exemple, une thermistance. Le second élément d'acquisition 24 est alors destiné à relever la tension définie par la différence de potentiel aux bornes de la thermistance de manière à obtenir une température.

Conformément à l'invention, les premier 14 et second 24 éléments d'acquisition sont destinés à conditionner un signal de tension, correspondant aux données.

En particulier, le signal de tension conditionné par le premier élément d'acquisition 14 a pour référence le potentiel de source filtré VA est dit signal à la source. Ce signal à la source conditionné par le premier élément 14 correspond par exemple à des données numériques de l'intensité acquise I.

En revanche, le signal de tension conditionné par le second élément d'acquisition 24 a pour référence le potentiel de masse VM et est dit signal à la masse. Ce signal à la masse conditionné par le second élément 24 correspond par exemple à des données numériques de la tension acquise U ou éventuellement de la température acquise.

Afin de traiter les données numériques des signaux de tension, la chaîne 12 comprend encore un élément 30 de traitement des données des paramètres mesurés. Par exemple, l'élément de traitement 30 comprend un microcontrôleur.

L'élément de traitement 30 permet notamment de réaliser des calculs de moyenne entre différentes valeurs des paramètres acquis.

Cet élément de traitement 30 est alimenté par une tension définie par la différence entre le potentiel intermédiaire VC et le potentiel de masse VM.

La chaîne 12 comprend encore un élément de communication 32 avec un organe électrique (non représenté) extérieur à cette chaîne 12.

De préférence, cet élément de communication 32 est alimenté par une tension définie par la différence entre le potentiel intermédiaire VC et le potentiel de masse VM et est relié à l'élément de traitement 30.

En outre, la chaîne 12 comprend un élément comparateur 36 de l'intensité acquise I avec un seuil d'intensité prédéterminé.

L'élément comparateur 36 est alimenté par une tension définie par la différence entre le potentiel de source VA et le potentiel supérieur VB à ce potentiel de source VA.

De préférence, l'élément comparateur 36 est également relié au potentiel de source VA par l'intermédiaire de l'élément de filtrage 18.

Ainsi, l'élément comparateur 36 est alimenté par une tension définie par la différence entre le potentiel supérieur VB et le potentiel de source filtré VA et le signal a pour référence le potentiel de source VA et est dit signal à la source.

Cet élément comparateur 36 est destiné à conditionner un signal de tension d'activation/désactivation d'au moins un élément de la chaîne 12 alimenté par une tension définie par la différence entre le potentiel intermédiaire VC et le potentiel de masse VM, en fonction du franchissement à la hausse/à la baisse du seuil par l'intensité I acquise.

L'élément de la chaîne 12 susceptible d'être activé ou désactivé par le signal de tension conditionné par l'élément comparateur 36 est par exemple le second élément d'acquisition 24 ou l'élément de traitement 30.

Le premier élément d'acquisition 14 et l'élément comparateur 36, étant alimentés par une tension définie par une différence entre le potentiel de source filtré VA et le potentiel supérieur VB au potentiel de source, forment un premier ensemble E1 d'éléments de la chaîne 12.

En particulier, dans le premier ensemble E1, le premier élément 14 et l'élément comparateur 36 sont reliés entre eux de façon à échanger entre eux des signaux de tension ayant pour référence le potentiel de source filtré VA dits signaux à la source.

Le second élément d'acquisition 24, l'élément de traitement 30 et l'élément de communication 32, étant alimentés par une tension définie par une différence entre le potentiel intermédiaire VC et le potentiel de masse VM, forment un second ensemble E2 d'éléments de la chaîne 12.

En particulier, dans ce second ensemble E2, l'élément de traitement 30 relie entre eux le second élément d'acquisition 24 et l'élément de communication 32 de façon à échanger entre eux des signaux de tension ayant pour référence le potentiel de masse VM dits signaux à la masse.

Par ailleurs, afin de permettre l'échange de signaux entre les éléments du premier ensemble E1 et les éléments du second ensemble E2, la chaîne 12 comprend avantageusement un élément d'adaptation 38 reliant entre eux les premier E1 et second E2 ensembles. Dans l'exemple décrit, l'élément d'adaptation 38 relie entre eux l'élément comparateur 36 et l'élément de traitement 30.

De façon avantageuse, l'élément d'adaptation 38 permet d'adapter le potentiel de référence du signal à la source au potentiel de référence du signal à la masse et réciproquement.

Ainsi, dans cet exemple, l'élément d'adaptation 38 est relié d'une part au potentiel de source filtré VA et d'autre part au potentiel de masse VM ce qui lui permet d'adapter le potentiel de référence du signal à la source au potentiel de référence du signal à la masse et réciproquement.

Dans l'exemple décrit, le dispositif 10 comprend une pastille semi-conductrice P dans laquelle sont regroupés le premier ensemble E1 d'éléments de la chaîne 12 alimentés par une tension définie par une différence entre le potentiel de source VA et le potentiel supérieur VB au potentiel de source VA et le deuxième ensemble E2 d'éléments de la chaîne 12 alimentés par une tension définie par une différence entre le potentiel de masse VM et le potentiel intermédiaire VC.

Dans une première variante illustrée par la figure 2, le dispositif de mesure 10 comprend des première P1 et seconde P2 pastilles semi-conductrices comportant chacune des pistes reliées à des éléments de la chaîne 12, les pistes de la seconde pastille P2 ayant des dimensions plus faibles que les pistes de la première pastille P1.

Par exemple, la première pastille P1 comprend les résistances R1, R2, les premier 14 et second 24 éléments d'acquisition, l'élément régulateur 26, l'élément de communication 32, l'élément comparateur 36 et l'élément d'adaptation 38, ces éléments nécessitant des pistes gravées de dimensions relativement importantes, notamment pour l'alimentation de ces éléments ou encore pour l'acquisition d'intensité de courant ou de tension relativement élevées. La deuxième pastille semi-conductrice P2 comprend au moins le microcontrôleur 30, cet élément nécessitant des pistes gravées de dimensions relativement faibles.

Dans cet exemple, le shunt 22 et l'élément de filtrage 18 sont disposés à l'extérieur des deux pastilles semi-conductrices P1 et P2.

Dans une deuxième variante non illustrée, le premier ensemble E1 d'éléments de la chaîne 12 alimentés par une tension définie par une différence entre le potentiel de source VA et le potentiel VB supérieur au potentiel de source VA et le second ensemble E2 d'éléments de la chaîne 12 alimentés par une tension définie par une différence entre le potentiel de masse VM et le potentiel intermédiaire VC sont répartis respectivement dans les première P1 et seconde P2 pastilles semi-conductrices.

On va maintenant décrire les principaux aspects du fonctionnement du dispositif 10 liés à l'invention.

On considère initialement le moteur du véhicule à l'arrêt (véhicule en stationnement). Dans ce cas, la consommation du courant de la batterie du véhicule est relativement faible car n'alimentant que des organes électriques du véhicule automobile en état de veille, et l'intensité du courant I circulant dans le circuit 20 est inférieure au seuil prédéterminé.

Ainsi, seuls l'élément comparateur 36 et le premier élément d'acquisition 14 sont alimentés par l'élévateur de tension 16, afin de permettre une mesure de l'intensité du courant I en continu.

Lorsque le moteur du véhicule automobile tourne (démarrage ou roulage du véhicule), certains organes électriques du véhicule requerrant un courant d'alimentation d'intensité élevée sont activés. L'intensité du courant I franchit alors le seuil à la hausse de sorte que l'élément comparateur 36 conditionne un signal de tension d'activation de l'élément de traitement 30. L'élément de traitement 30 est alors alimenté par le régulateur de tension 26.

Des éléments du second ensemble E2 de la chaîne 12, notamment le second élément d'acquisition 24 et l'élément de communication 32 sont également activés, par exemple par l'intermédiaire de l'élément de traitement 30 et sont alimentés par le régulateur de tension 26.

Lorsque l'intensité du courant I circulant dans le circuit 20 franchit le seuil à la baisse, l'élément comparateur 36 conditionne un signal de tension de désactivation de l'élément de traitement 30. L'élément de traitement 30 désactive alors le second élément d'acquisition 24 ainsi que l'élément de communication 32.

L'invention tire profit du fait que seuls quelques éléments de la chaîne 12, notamment le premier élément d'acquisition 14, l'élément comparateur 36 et l'élément d'adaptation 38, nécessitent d'avoir pour potentiel de référence le potentiel de source filtré VA et ce afin d'avoir une mesure précise de l'intensité. Les autres éléments, notamment le second élément d'acquisition 24 ont pour potentiel de référence le potentiel de masse VM et sont alimentés de ce fait par une tension définie par la différence entre un potentiel intermédiaire VC et ce potentiel de masse VM.

De façon avantageuse, les différents éléments de la chaîne 12 échangent des signaux de tension entre eux par l'intermédiaire de l'élément d'adaptation 38.

Grâce au dispositif de mesure 10 de l'invention, la consommation de courant de la batterie est limitée, en particulier lorsque le moteur est à l'arrêt, tout en maintenant une relativement grande précision de mesure de l'intensité I.

## Revendications

1. Dispositif (10) de mesure de paramètres, du type comprenant une chaîne (12) d'acquisition et de traitement de données comportant :
- un premier élément (14) d'acquisition d'un premier paramètre alimenté par une tension définie par la différence entre un potentiel (VA) de source d'alimentation électrique et un potentiel supérieur (VB) à ce potentiel de source (VA) et destiné à conditionner un signal de tension, dit signal à la source, correspondant aux données, ayant pour référence le potentiel de source (VA), le premier paramètre étant une intensité (I) d'un courant circulant dans un circuit (20) raccordé au potentiel de source (VA) et étant fourni par un shunt (22) relié à ce circuit (20),
- un second (24) élément d'acquisition d'un second paramètre fourni par un pont diviseur de tension (28) raccordé au potentiel de source (VA),
**caractérisé en ce que** le second élément d'acquisition (24) est alimenté par une tension définie par la différence entre un potentiel de masse (VM), inférieur au potentiel de source (VA), et un potentiel intermédiaire (VC) compris entre le potentiel de masse (VM) et le potentiel de source (VA), et est destiné à conditionner un signal de tension, dit signal à la masse, correspondant aux données, ayant pour référence le potentiel de masse (VM).

2. Dispositif (10) de mesure selon la revendication 1, dans lequel le second paramètre est une tension (U) définie par la différence entre le potentiel de source (VA) et le potentiel de masse (VM) fournie par le pont diviseur de tension (28) au second élément d'acquisition (24).

3. Dispositif (10) de mesure selon la revendication 1, dans lequel le second paramètre est une température fournie par le pont diviseur de tension au second élément d'acquisition (24), ce pont diviseur de tension comprenant au moins une thermistance.

4. Dispositif (10) de mesure selon l'une quelconque des revendications 1 à 3, dans lequel la chaîne (12) comprend de plus un élément (30) de traitement d'au moins le premier paramètre, alimenté par une tension définie par la différence entre le potentiel de masse (VM) et le potentiel intermédiaire (VC).

5. Dispositif (10) de mesure selon l'une quelconque des revendications 1 à 4, dans lequel la chaîne comprend un élément (32) de communication avec un organe électrique extérieur à cette chaîne (12), cet élément de communication (32) étant alimenté par une tension définie par la différence entre le potentiel de masse (VM) et le potentiel intermédiaire (VC).

6. Dispositif (10) de mesure selon l'une quelconque des revendications 1 à 5, dans lequel la chaîne comprend un élément (36) comparateur de l'intensité acquise (I) avec un seuil d'intensité prédéterminé, alimenté par une tension définie par la différence entre le potentiel de source (VA) et le potentiel supérieur (VB) à ce potentiel de source (VA), cet élément comparateur (36) étant destiné à conditionner un signal de tension d'activation/désactivation d'au moins un élément de la chaîne (12) alimenté par une tension définie par la différence entre le potentiel de masse (VM) et le potentiel intermédiaire (VC), en fonction du franchissement à la hausse/à la baisse du seuil par l'intensité acquise (I), le signal ayant pour référence le potentiel de source (VA).

7. Dispositif (10) selon l'une quelconque des revendications 1 à 6, dans lequel la chaîne (12) comprend de plus un élément (38) d'adaptation, reliant un premier ensemble (E1) d'éléments de la chaîne (12) comprenant au moins le premier élément d'acquisition (14), chaque élément du premier ensemble (E1) étant alimenté par une tension définie par une différence entre le potentiel de source (VA) et le potentiel supérieur (VB) au potentiel de source (VA) avec un second ensemble (E2) d'éléments de la chaîne (12) comprenant au moins le second élément d'acquisition (24), chaque élément du second ensemble (E2) étant alimenté par une tension définie par une différence entre le potentiel de masse (VM) et le potentiel intermédiaire (VC), de façon à adapter le potentiel de référence du signal à la source au potentiel de référence du signal à la masse et réciproquement.

8. Dispositif (10) de mesure selon la revendication 7, comprenant une pastille semi-conductrice (P) dans laquelle sont regroupés les premier (E1) et second (E2) ensembles d'éléments de la chaîne (12).

9. Dispositif (10) de mesure selon la revendication 7, comprenant des première (P1) et seconde (P2) pastilles semi-conductrices dans lesquelles sont répartis respectivement les premier (E1) et deuxième (E2) ensembles d'éléments de la chaîne (12).

10. Dispositif (10) de mesure selon l'une quelconque des revendications 1 à 7, comprenant des première (P1) et seconde (P2) pastilles semi-conductrices comportant chacune des pistes reliées à des éléments de la chaîne (12), les pistes de la deuxième pastille (P2) ont des dimensions plus faibles que les pistes de la première pastille (P1).

11. Dispositif (10) de mesure selon l'une quelconque des revendications 1 à 10, dans lequel le potentiel de source (VA) est une borne positive de batterie de véhicule automobile.

12. Dispositif (10) de mesure selon l'une quelconque des revendications 1 à 11, dans lequel le potentiel intermédiaire (VC) est fourni par un élément d'alimentation formant régulateur de tension (26), alimenté par une tension définie par la différence entre le potentiel de source (VA) et le potentiel de masse (VM).

13. Dispositif (10) de mesure selon l'une quelconque des revendications 12 à 14, dans lequel le régulateur de tension (26) est relié au potentiel de source (VA) par l'intermédiaire d'un élément (18) de filtrage de tension.

14. Dispositif (10) de mesure selon l'une quelconque des revendications 1 à 13, dans lequel le potentiel supérieur (VB) au potentiel de source (VA) est fourni par un élément d'alimentation formant élévateur de tension (16), alimenté par une tension définie par la différence entre le potentiel de source (VA) et le potentiel de masse (VM).

15. Dispositif (10) de mesure selon la revendication 14, dans lequel l'élévateur de tension (16) est relié au potentiel de source (VA) par l'intermédiaire d'un élément (18) de filtrage de tension.

## Claims

1. Device (10) for measurement of parameters, of the type comprising a data acquisition and processing chain (12), comprising:
- a first element (14) for acquisition of a first parameter, which is supplied by a voltage defined by the difference between an electrical supply source potential (VA) and a potential (VB) which is higher than this source potential (VA), and is designed to condition a voltage signal, known as the source signal, corresponding to the data, and which has as a reference the source potential (VA), the first parameter being an intensity (I) of a current which circulates in a circuit (20) which is connected to the source potential (VA), and is supplied by a shunt (22) which is connected to this circuit (20); and
- a second element (24) for acquisition of a second parameter which is supplied by a voltage-divider bridge (28) which is connected to the source potential (VA),
**characterised in that** the second acquisition element (24) is supplied by a voltage which is defined by the difference between an earthing potential (VM) which is lower than the source potential (VA), and an intermediate potential (VC) which is contained between the earthing potential (VM) and the source potential (VA), and is designed to condition a voltage signal, known as the earthing signal, corresponding to the data, and which has as a reference the earthing potential (VM).

2. Measurement device (10) according to claim 1, wherein the second parameter is a voltage (U) which is defined by the difference between the source potential (VA) and the earthing potential (VM) which is supplied by the voltage-divider bridge (28) to the second acquisition element (24).

3. Measurement device (10) according to claim 1, wherein the second parameter is a temperature which is supplied by the voltage-divider bridge to the second acquisition element (24), this voltage-divider bridge comprising at least one thermistor.

4. Measurement device (10) according to any one of claims 1 to 3, wherein the chain (12) additionally comprises an element (30) for processing of at least the first parameter, which element is supplied by a voltage which is defined by the difference between the earthing potential (VM) and the intermediate potential (VC).

5. Measurement device (10) according to any one of claims 1 to 4, wherein the chain (12) comprises an element (32) for communication with an electrical unit outside this chain (12), this communication element (32) being supplied by a voltage which is defined by the difference between the earthing potential (VM) and the intermediate potential (VC).

6. Measurement device (10) according to any one of claims 1 to 5, wherein the chain comprises an element (36) for comparison of the intensity (I) acquired with a predetermined intensity threshold, which element is supplied by a voltage which is defined by the difference between the source potential (VA) and the potential (VB) which is higher than this source potential (VA), this comparison element (36) being designed to condition a voltage signal for activation / deactivation of at least one element of the chain (12) which is supplied by a voltage which is defined by the difference between the earthing potential (VM) and the intermediate potential (VC), according to the upward or downward clearance of the threshold by the intensity (I) acquired, the signal having as a reference the source potential (VA).

7. Device (10) according to any one of claims 1 to 6, wherein the chain (12) additionally comprises an adaptation element (38), which connects a first assembly (E1) of elements of the chain (12), comprising at least the first acquisition element (14), each element of the first assembly (E1) being supplied by a voltage which is defined by a difference between the source potential (VA) and the potential (VB) which is higher than the source potential (VA), to a second assembly (E2) of elements of the chain (12) comprising at least the second acquisition element (24), each element of the second assembly (E2) being supplied by a voltage which is defined by a difference between the earthing potential (VM) and the intermediate potential (VC), such as to adapt the reference potential of the signal at the source to the reference potential of the signal at the earth, and vice versa.

8. Measurement device (10) according to claim 7, comprising a semiconductor chip (P) on which the first (E1) and second (E2) assemblies of elements of the chain (12) are grouped.

9. Measurement device (10) according to claim 7, comprising first (P1) and second (P2) semiconductor chips on which the first (E1) and second (E2) assemblies of elements of the chain (12) are distributed respectively.

10. Measurement device (10) according to any one of claims 1 to 7, comprising first (P1) and second (P2) semiconductor chips, each comprising tracks which are connected to elements of the chain (12), the tracks of the second chip (P2) having dimensions which are smaller than the tracks of the first chip (P1).

11. Measurement device (10) according to any one of claims 1 to 10, wherein the source potential (VA) is a positive terminal of a motor vehicle battery.

12. Measurement device (10) according to any one of claims 1 to 11, wherein the intermediate potential (VC) is provided by a supply element forming a voltage regulator (26), which element is supplied by a voltage which is defined by the difference between the source potential (VA) and the earthing potential (VM).

13. Measurement device (10) according to any one of claims 12 to 14, wherein the voltage regulator (26) is connected to the source potential (VA) by means of a voltage filtering element (18).

14. Measurement device (10) according to any one of claims 1 to 13, wherein the potential (VB) which is higher than the source potential (VA) is provided by a supply element which forms a voltage booster (16), which element is supplied by a voltage which is defined by the difference between the source potential (VA) and the earthing potential (VM).

15. Measurement device (10) according to claim 14, wherein the voltage booster (16) is connected to the source potential (VA) by means of a voltage filtering element (18).

## Patentansprüche

1. Vorrichtung (10) zur Messung von Parametern von der Art, die eine Datenerfassungs- und Verarbeitungskette (12) enthält, die aufweist:
- ein erstes Element (14) zur Erfassung eines ersten Parameters, das mit einer durch die Differenz zwischen einem Stromquellenpotential (VA) und einem höheren Potential (VB) als dieses Quellenpotential (VA) definierten Spannung versorgt wird und dazu bestimmt ist, ein den Daten entsprechendes Spannungssignal, Quellensignal genannt, aufzubereiten, das als Bezug das Quellenpotential (VA) hat, wobei der erste Parameter eine Stärke (I) eines in einem an das Quellenpotential (VA) angeschlossenen Stromkreis (20) fließenden und von einem mit diesem Stromkreis (20) verbundenen Shunt (22) gelieferten Stroms ist,
- ein zweites Element (24) zur Erfassung eines zweiten Parameters, der von einer an das Quellenpotential (VA) angeschlossenen Spannungsteilerbrücke (28) geliefert wird,
**dadurch gekennzeichnet, dass** das zweite Erfassungselement (24) mit einer durch die Differenz zwischen einem Massepotential (VM) geringer als das Quellenpotential (VA) und einem zwischen dem Massepotential (VM) und dem Quellenpotential (VA) liegenden Zwischenpotential (VC) definierten Spannung versorgt wird und dazu bestimmt ist, ein den Daten entsprechendes Spannungssignal, Massesignal genannt, aufzubereiten, das als Bezug das Massepotential (VM) hat.

2. Messvorrichtung (10) nach Anspruch 1, bei der der zweite Parameter eine durch die Differenz zwischen dem Quellenpotential (VA) und dem Massepotential (VM) definierte Spannung (U) ist, die von der Spannungsteilerbrücke (28) an das zweite Erfassungselement (24) geliefert wird.

3. Messvorrichtung (10) nach Anspruch 1, bei der der zweite Parameter eine von der Spannungsteilerbrücke an das zweite Erfassungselement (24) gelieferte Temperatur ist, wobei diese Spannungsteilerbrücke mindestens einen Thermistor enthält.

4. Messvorrichtung (10) nach einem der Ansprüche bis 3, bei der die Kette (12) außerdem ein Element (30) zur Verarbeitung mindestens des ersten Parameters enthält, das mit einer durch die Differenz zwischen dem Massepotential (VM) und dem Zwischenpotential (VC) definierten Spannung versorgt wird.

5. Messvorrichtung (10) nach einem der Ansprüche 1 bis 4, bei der die Kette ein Element (32) zur Kommunikation mit einem elektrischen Organ außerhalb dieser Kette (12) enthält, wobei dieses Kommunikationselement (32) mit einer durch die Differenz zwischen dem Massepotential (VM) und dem Zwischenpotential (VC) definierten Spannung versorgt wird.

6. Messvorrichtung (10) nach einem der Ansprüche 1 bis 5, bei der die Kette ein Element (36) zum Vergleich der erfassten Stärke (I) mit einer vorbestimmten Stärkeschwelle enthält, das mite einer durch die Differenz zwischen dem Quellenpotential (VA) und dem höheren Potential (VB) als dieses Quellenpotential (VA) definierten Spannung versorgt wird, wobei dieses Vergleichselement (36) dazu bestimmt ist, ein Spannungssignal zur Aktivierung/Deaktivierung mindestens eines Elements der Kette (12) aufzubereiten, das mit einer durch die Differenz zwischen dem Massepotential (VM) und dem Zwischenpotential (VC), in Abhängigkeit von dem Überschreiten der Schwelle nach oben oder nach unten durch die erfasste Stärke (I), definierten Spannung versorgt wird, wobeid das Signal das Quellenpotential (VA) als Bezug hat.

7. Messvorrichtung (10) nach einem der Ansprüche 1 bis 6, bei der die Kette (12) außerdem ein Anpassungselement (38) enthält, das eine erste Einheit (E1) von Elementen der Kette (12), die mindestens das erste Erfassungselement (14) enthält, wobei jedes Element der ersten Einheit (E1) mit einer durch eine Differenz zwischen dem Quellenpotential (VA) und dem höheren Potential (VB) als das Quellenpotential (VA) definierten Spannung versorgt wird, mit einer zweiten Einheit (E2) von Elementen der Kette (12) verbindet, die mindestens das zweite Erfassungselement (24) enthält, wobei jedes Element der zweiten Einheit (E2) mit einer durch eine Differenz zwischen dem Massepotential (VM) und dem Zwischenpotential (VC) definierten Spannung versorgt wird, um das Bezugspotential des Quellensignals an das Bezugspotential des Massesignals und umgekehrt anzupassen.

8. Messvorrichtung (10) nach Anspruch 7, die ein Halbleiterprättchen (P) enthält, auf dem die erste (E1) und die zweite (E2) Einheit von Elementen der Kette (12) zusammengefasst sind.

9. Messvorrichtung (10) nach Anspruch 7, die ein erstes (P1) und ein zweites (P2) Halbleiterplattchen aufweist, auf denen die erste (E1) bzw. die zweite (E2) Einheit von Elementen der Kette (12) verteilt sind.

10. Messvorrichtung (10) nach einem der Ansprüche 1 bis 7, die ein erstes (P1) und ein zweites (P2) Halbleiterplättchen enthält, die je mit Elementen der Kette (12) verbundene Bahnen aufweisen, wobei die Bahnen des zweiten Plättchens (P2) geringere Abmessungen haben als die Bahnen des ersten Plättchens (P1).

11. Messvorrichtung (10) nach einem der Ansprüche 1 bis 10, bei der das Quellenpotential (VA) eine positive Klemme einer Kraftfahrzeugbatterie ist.

12. Messvorrichtung (10) nach einem der Ansprüche 1 bis 11, bei der das Zwischenpotential (VC) von einem einen Spannungsregler (26) bildenden Versorgungselement geliefert wird, das mit einer durch die Differenz zwischen dem Quellenpotential (VA) und dem Massepotential (VM) definierten Spannung versorgt wird.

13. Messvorrichtung (10) nach einem der Ansprüche 1 bis 12, bei der des Spannungsregler (26) über ein Spannungsfilterelment (18) mit dem Quellenpotential (VA) verbunden ist.

14. Messvorrichtung (10) nach einem der Ansprüche 1 bis 13, bei der das höhere Potential (VB) als das Quellenpotential (VA) von einem einen Spannungserhöher (16) bildenden Versorgungselement geliefert wird, das mit einer durch die Differenz zwischen dem Quellenpotential (VA) und dem Massepotential (VM) definierten Spannung versorgt wird.

15. Messvorrichtung (10) nach Anspruch 14, bei der der Spannungserhöher (16) über ein Spannungsfilterelement (18) mit dem Quellenpotential (VA) verbunden ist.
